# EUROPEAN PATENT APPLICATION

(11) **EP 4 576 184 A1**
(43) Date of publication of application: **25.06.2025**
(21) Application number: 23219013.2
(22) Date of filing: 21.12.2023
(51) Int. Cl.: H01L 21/768, H01L 21/3213

(54) **A METHOD FOR PATTERN IMPROVEMENT**

(71) Applicant: AlixLabs AB, 22363 Lund (SE)
(72) Inventor: Sundqvist, Jonas, 01328 Dresden (DE); Jafari Jam, Reza, 22487 Lund (SE); Suyatin, Dmitry, 22472 Lund (SE)
(74) Representative: Invent Horizon IP

(57) **Abstract**

A method for sidewall roughness reduction of features on a substrate is disclosed. The features are spaced apart and have respective field regions and sidewalls. The method comprises forming a patterned and selectively protecting masking layer so that at least part of the field regions are masked and the sidewalls are unmasked. The method comprisese performing dry etching in a process chamber enclosing the substrate, creating a horizontal component of a direction of the etching by setting a pressure in the process chamber to exceed a defined pressure threshold for sidewall etching. The horizontal component etches the unmasked sidewalls for roughness reduction of the sidewalls.

## Description

### Field

The technology relates to the field of semiconductor fabrication, specifically focusing on the reduction of sidewall roughness in features on a substrate. The technology is especially important for improving line edge roughness (LER). This is particularly important for scaling down electronic devices and improving the performance and reliability of micro- and nano-scale devices, such as integrated circuits, waveguides, and Transistors.

### Background

Semiconductor fabrication is a critical process in the manufacturing of electronic devices, such as integrated circuits and transistors. As the demand for smaller and more powerful devices increases, the size of the features on semiconductor substrates has been continuously shrinking. One of the challenges associated with this trend is the issue of line edge roughness (LER) in the fabrication process.

LER is defined as the root-mean-square deviation of the line edge profile shape from the straight line in the horizontal plane. The LER is usually in the range of 0.5-5 nm. LER causes size variation along the pattern, which can lead to changes in gate dimensions in transistors, consequently increasing the threshold voltage or leakage current. The problem becomes more pronounced when the size of the features shrinks towards sub-10 nm, as the LER becomes comparable to the feature sizes, degrading the device performances and manufacturing yield significantly.

There are several causes for LER, including resist properties, resist development conditions, and exposure parameters. Inadequate resist properties can lead to uneven exposure and development, resulting in LER. Resist development conditions, such as temperature, time, and developer concentration, can also impact LER if not optimized. Exposure parameters, such as exposure dose, focus, and illumination conditions, can affect LER as well, with inaccurate or non-uniform exposure causing variations in the resist profile.

Various methods have been proposed to address the issue of LER in semiconductor fabrication. Some approaches focus on improving lithography parameters, such as the shot noise properties of extreme ultraviolet (EUV) lithography. Others aim to enhance resist properties, for example, by improving the absorption of light by the resist to reduce shot noise. Some solutions involve tilting the substrate holder to provide inclined etching of the sidewalls to reduce roughness, while others use a ribbon plasma to provide the sidewall etching.

However, these methods have their limitations and may not be capable of improving LER to an acceptable level for the sub-10 nm regime, where LER is comparable to the feature size. Additionally, some of these methods require changes in the current state-of-the-art equipment, such as tilting the substrate or modifying the beam direction using a ribbon plasma, which can be costly and time-consuming to implement. There remains a need for an effective and efficient method to reduce LER in semiconductor fabrication, particularly for sub-10 nm feature sizes, without requiring significant modifications to existing equipment.

### Summary

According to a first aspect of the disclosure, a method is provided for sidewall roughness reduction of features on a substrate. The features are spaced apart and have respective field regions and sidewalls. The field regions (<- *to be removed, kept to not erase comments*). The method comprises forming a patterned and selectively protecting masking layer so that at least part of the field regions are masked and the sidewalls are unmasked. The method also comprises performing dry etching in a process chamber enclosing the substrate. This involves creating a horizontal component of a direction of the etching by setting a pressure in the process chamber to exceed a defined pressure threshold for a sidewall etching. The horizontal component etches the unmasked sidewalls for said roughness reduction of the sidewalls. This method allows for precise etching of the sidewalls, and thus reducing the roughness of the sidewalls, without requiring on tilting of the substrate or particle beam to target the sidewalls with directional etching. The process is thus less complex than previous solutions to implement.

Optionally in some examples, the defined pressure threshold for sidewall etching is 40 mTorr. This specific pressure threshold has been found to be particularly effective in creating the desired horizontal component of the etching direction, leading to a more efficient and effective roughness reduction.

Optionally in some examples, the dry etching is self-limiting, whereby the dry etching stops when the sidewall roughness is reduced with a threshold amount. The plasma energy is lower than the binding energy of the bulk of the material of the original features. This allows the etch process to stop after the roughness is removed and the applied plasma has lower energy than the remaining material, preventing over-etching.

Optionally in some examples, the sidewall roughness is reduced by at least 50%. This significant reduction in roughness can greatly improve the performance and reliability of the features on the substrate.

Optionally in some examples, a line edge roughness of the sidewalls is reduced to a value below 1 nm root mean square (RMS). The line edge roughness (LER) here quantified as the root-mean-square (RMS) deviation of the line edge profile shape from the straight line in the horizontal plane. This extremely low level of roughness can further enhance the performance of the features, particularly in applications where very high precision is required.

Optionally in some examples, the method further comprises a self-limiting reaction. A self-limiting reaction is a reaction that slows down or stops as a function of time or, equivalently, as a function of species dosage. Self-limiting reactions may include, but are not limited to chemisorption, deposition, conversion (e.g., oxidation, nitridation), and extraction. Chemisorption is a chemical adsorption process, caused by a reaction on an exposed surface, which creates an electronic bond between the surface and the adsorbate with a binding energy greater than 0.5 eV per adsorbed species. During the chemical reaction, a distinct chemical species is created on the adsorbent surface, which causes the bond to be created. In the extraction case, the original material is a compound, with the modification removing one element preferentially from the surface, while the other element is removed in the subsequent removal step. These reactions can provide additional control over the etching process, further enhancing the precision and effectiveness of the roughness reduction.

Optionally in some examples, the self-limiting reaction or dry etching is selectively applied to specific areas of the substrate. This selectivity means that processes are applied preferentially on some specific surfaces or materials while being suppressed on other surfaces or materials, i.e. the suppressed processes have a substantially reduced process rate. This selective application allows for even greater control over the etching process, enabling the roughness reduction to be tailored to the specific needs of different areas of the substrate.

Optionally in some examples, the dry etching is performed using atomic layer etching (ALE). ALE is a highly precise etching technique that can further enhance the effectiveness and precision of the roughness reduction.

Optionally in some examples, the dry etching is a cyclic etching process. This cyclic process can provide additional control over the etching, allowing for more precise and effective roughness reduction.

Optionally in some examples, the dry etching is selective to a material comprising any of silicon, silicon oxide, silicon nitride, hafnium oxide, aluminium oxide. This selectivity can be particularly beneficial in applications where the features on the substrate are made of these materials, as it allows for precise and effective roughness reduction without damaging other materials on the substrate.

Optionally in some examples, the method further comprises rapid surface temperature cycling. Rapid surface temperature cycling here is defined as rapid heating and cooling of surfaces which can be done once or repeated multiple times. The process of heating takes less than 5 min in some examples, typically less than 30 s. This can enhance the effectiveness of the etching process, leading to more efficient and effective roughness reduction.

Optionally in some examples, the rapid surface temperature cycling is done through surface exposure to plasma. This can provide a highly effective means of rapidly cycling the surface temperature, further enhancing the effectiveness of the etching process.

Optionally in some examples, the rapid surface temperature cycling is assisted with flashlight. This can provide a convenient and effective means of rapidly cycling the surface temperature, further enhancing the effectiveness of the etching process.

Optionally in some examples, the rapid surface temperature cycling assisted with flashlight is done using a laser light source. This can provide a highly precise and effective means of rapidly cycling the surface temperature, further enhancing the effectiveness of the etching process.

Optionally in some examples, the features on the substrate comprises any of micro- and nano-scale devices, waveguides, transistors, fins, ridges, trenches, holes, and/or pillars. This method can be applied to a wide range of different features, making it highly versatile and applicable to a wide range of different applications.

### Brief Description of the Drawings

Examples are described in more detail below with reference to the appended drawings.
Figure 1 is a schematic representation of the desired size and profile of the patterned features on a substrate.
Figure 2 is an illustration of the real surface of the features before completing the method for sidewall roughness reduction, also known as Atomic Level Improvement.
Figure 3 shows a large structure after lithography and before Atomic level Pitch Splitting (APS).
Figure 4 depicts the structure after APS and before completing the method for sidewall roughness reduction.
Figure 5 illustrates the structure after APS and after completing the method for sidewall roughness reduction.

### Detailed Description

The detailed description set forth below provides information and examples of the disclosed technology with sufficient detail to enable those skilled in the art to practice the disclosure.

### 1. Method for Sidewall Roughness Reduction of Features on a Substrate

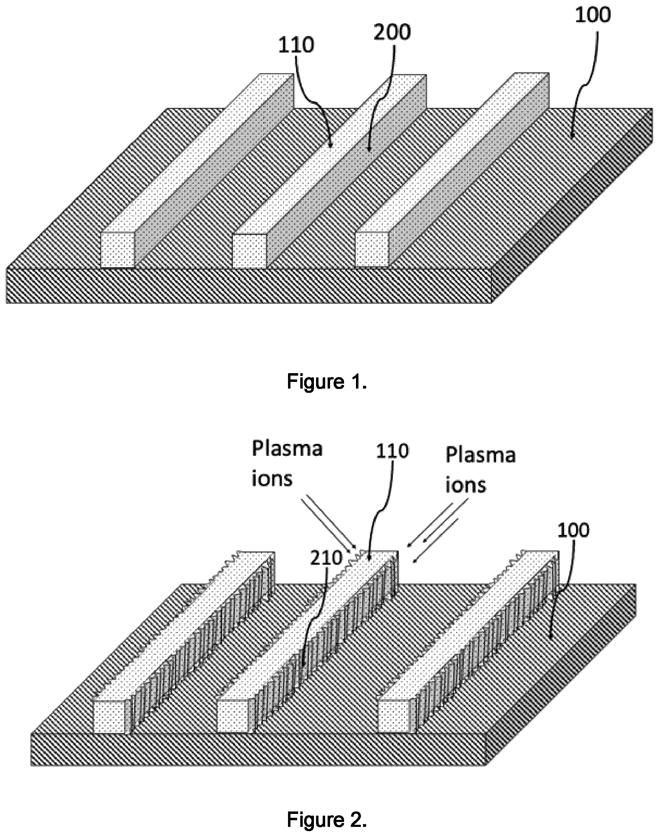

Figure 1 shows a schematic representation of the desired size and profile of the patterned features on a substrate 100. The features are also referred to as structures and could be anything including micro- and nano-scale devices, waveguides or transistors. The features can be of various types, such as ridges, trenches, holes, pillars, and more, and can be made from a variety of materials, including semiconductors, metals, dielectrics, and polymers.

The features have field regions 110 and sidewalls 200. The desired or ideal profile of the features is smooth and uniform, with minimal roughness on the sidewalls. The field regions 110 are defined here as regions with horizontal surfaces, i.e. surfaces which are parallel or close to parallel (<20° deviation) to the main surface of the substrate 100 or coincide with the main surface of the substrate 100. The field regions are shown as, for example, features 110 in Figures 1 and 2.

However, due to Line Edge Roughness (LER), the actual profile is looking like Figure 2. Instead of the surfaces 200 of the sidewalls in Figure 1, the sidewalls have surfaces 210, which have features that make the profile slightly larger as compared to the desired profile. Figure 2 is thus an illustration of the real surface of the features before completing the method for sidewall roughness reduction, also known as Atomic Level Improvement, as described below. The sidewalls 210 of the features exhibit roughness, which can negatively impact the performance of the features in their intended applications. The sidewall roughness is defined here as profile deviations from the sidewall tangent plane. The sidewall surface roughness is quantified as the root-mean-square (RMS) of the sidewall profile deviations from the sidewall tangent plane.

The method for sidewall roughness reduction comprises forming a patterned and selectively protecting masking layer so that at least part of the field regions 110 are masked and the sidewalls 210 are unmasked. This masking layer is thus designed to protect certain areas of the substrate during the etching process, while leaving other areas, specifically the sidewalls of the features, exposed, i.e. being subjected to the treatment. The method comprises performing dry etching in a process chamber enclosing the substrate 100. The dry etching comprises creating a horizontal component of a direction of the etching by setting a pressure in the process chamber to exceed a defined pressure threshold for a sidewall etching. The horizontal component thus etches the unmasked sidewalls 210 for said roughness reduction of the sidewalls 210. Figure 2 illustrates a direction of the plasma ions which has a horizontal component, created by the high pressure dry etching. As the roughness of the sidewalls 210 is reduced with the present method the line edge roughness will approach the ideal pattern as illustrated in Figure 1.

The method can be implemented in currently available equipment, and no need for significant change in the fabrication line is required, which makes this method a cost effective and sustainable approach. This is in contrast to previous solutions for roughness reduction which are more complex, such as relying on tilting of the substrate or particle beam to target the sidewalls with directional etching. This process is thus versatile and applicable to a wide range of materials, including polymers, semiconductors, directrices, and metals. As compared to some available methods this method has the advantage that it does not need any hardware modification to provide the inclined etching to attack the sidewalls. In addition, this method is applicable to all process steps of semiconductor manufacturing, making it a versatile approach compared to other counterparts.

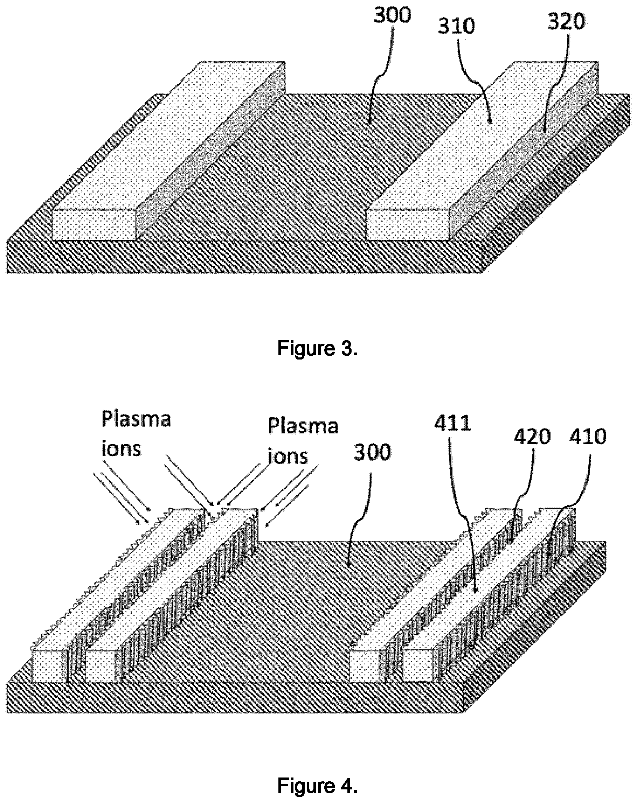

Figures 3 and 4 show an implementation of the present method during a so-called Atomic level Pitch Splitting (APS). Any structure including a fin could be fabricated by first, forming a large structure, such as exemplified in Figure 3, and then using APS to divide it into 2 or several fins or any other smaller structures. Figure 3 shows a substrate (surface 300) which could be any material including but not limited, metal, semiconductor, dielectric and polymer. The large structures are made any means of lithography and have field regions 310 and sidewalls 320.

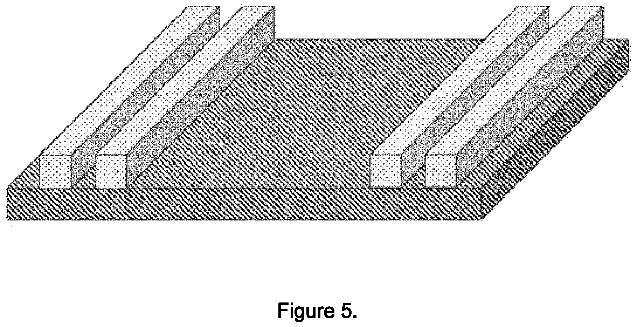

Using APS and as shown in Figure 4, field region 310 can be splitted in 2 or several parts forming new structures. An example of such a structure could be finFET. The new structure forms several surfaces such as 411 as top surface and 410 and 420 as sidewalls. Sidewalls 410 and 420 could have roughness that makes the profile deviates from the desired size. To reduce this roughness, the top surface 411 is covered with a mask and the sidewalls 410 and 420 are exposed to a low power plasma either in a continuous or cyclic scheme under high pressure to create the horizontal etching component to reduce the roughness. Figure 5 shows an example of a result after this method where all sidewalls (including 410 and 420) have significantly reduced roughness and reached the ideal size and profile which consequently improves device performance. Figure 5 accordingly illustrates the structure after APS and after completing the method for sidewall roughness reduction.

### 1.1. Protecting Masking Layer

The selective masking allows the etching process to specifically target the sidewalls of the features, which is where the roughness reduction is needed. In some examples, the protective mask is formed using selective deposition methods. These methods allow for the precise deposition of the masking material on the substrate, ensuring that only the desired areas are masked. The masking layer can be formed using any selective deposition methods, such as Chemical Vapor Deposition (CVD). Both methods allow for the deposition of thin, uniform layers of material on the substrate, but they differ in their mechanisms and the types of materials they can deposit.

The protecting masking layer can be made from a variety of materials, depending on the material of the features and the specific requirements of the etching process. The composition of the protecting masking layer can vary depending on the material of the features and the specific requirements of the etching process. The material used for the masking layer can be different from the material to be etched, which allows for better control over the etching process.

### 1.2. Substrate with Features

In some configurations, the substrate with features is the material on which the method for sidewall roughness reduction is performed. The substrate can be made from various materials, such as semiconductors, metals, dielectrics, and polymers. The features formed on the substrate can have various shapes, such as ridges, trenches, holes, pillars, and more. The features also have different aspect ratios, up to 1:10, and their sidewall roughness can be in the range of 0.5-5.0 nm RMS before the roughness reduction process.

### 1.3. High Pressure Dry Etching Process

In some implementations, the method for sidewall roughness reduction involves a high pressure dry etching process. This process is performed in a process chamber that encloses the substrate. The pressure in the chamber is set to exceed a defined pressure threshold for sidewall etching. This high pressure creates a horizontal component of the etching direction, which is responsible for etching the unmasked sidewalls of the features, thereby reducing their roughness.

### 1.3.1. Setting the Pressure Threshold for Sidewall Etching

In some configurations, the pressure threshold for sidewall etching is a parameter in the high pressure dry etching process. This threshold is set to a value that allows for the creation of a horizontal component of the etching direction. In some examples, a pressure above 40 mTorr is particularly advantageous for this purpose. The pressure in the process chamber is carefully controlled and monitored to ensure that it remains above this threshold during the etching process.

### 1.3.2. Impact of High Pressure on Ion Path and Etching Direction

In some examples, the high pressure in the process chamber has a significant impact on the path of the ions and the direction of the etching. The high pressure reduces the ions' mean free path, which results in a higher probability of collisions between the ions and the substrate. This, in turn, creates a horizontal component of the etching direction, which is responsible for etching the unmasked sidewalls of the features.

### 1.3.3. Setting and Monitoring of Pressure Threshold

In some configurations, the setting and monitoring of the pressure threshold is a part of the high pressure dry etching process. The pressure in the process chamber is carefully controlled and monitored to ensure that it remains above the defined pressure threshold for sidewall etching. This ensures that the horizontal component of the etching direction is maintained, which is necessary for the reduction of the sidewall roughness.

### 2.1. Reduction of Line Edge Roughness and Preservation of Critical Feature Dimensions

In some implementations, the sidewall etching process offers several benefits. Firstly, it reduces the line edge roughness of the features, which can improve the performance of the features in their intended applications. This roughness is defined as the profile deviations from the sidewall tangent plane. By reducing this roughness, the method improves the uniformity and smoothness of the features. In some examples, the line edge roughness can be reduced by at least 50%. In some examples, the line edge roughness can be reduced to a value below 1 nm RMS. The line edge roughness can be reduced to a value in the range 5-10 Angstrom (Å) RMS in some examples. Secondly, the sidewall etching process preserves the dimensions of the features, ensuring that the features retain their desired shape and size.

In some examples, another benefit of the sidewall etching process is the preservation of the dimensions of the features. Despite the etching of the sidewalls, the process does not significantly alter the overall size and shape of the features. This ensures that the features retain their desired dimensions, which is for their functionality.

### 2.2. Low Energy Dry Etch Process

In some implementations, the method for sidewall roughness reduction involves a low energy dry etch process. This process is designed to etch the unmasked sidewalls of the features without significantly affecting the bulk of the material. The energy of the plasma used in the etching process can be set lower than the binding energy of the bulk of the material, which helps to preserve the dimensions of the features.

The low energy dry etching process can thus be self-limiting in some examples. This means that the etching process stops when the sidewall roughness is reduced below a certain threshold. This self-limiting nature of the etching process helps to prevent over-etching of the sidewalls, which could potentially damage the features or alter their dimensions.

### 3. Post-Etching Processes

In some examples, after the high pressure dry etching process, further post-etching processes can be performed. These processes comprise rapid surface temperature cycling and self-limiting reaction processes. These processes are configured to further enhance the results of the etching process and to ensure the preservation of the dimensions of the features.

### 3.1. Rapid Surface Temperature Cycling

In some examples, rapid surface temperature cycling is performed after the high pressure dry etching process. This process involves rapidly changing the temperature of the substrate surface, which can help to further reduce the roughness of the sidewalls. The rapid surface temperature cycling can be achieved through various methods, such as surface exposure to plasma or the use of a flashlight or a laser light source.

### 3.2. Self-Limiting Reaction Processes

In some examples, the method for sidewall roughness reduction can involve self-limiting reactions. These processes involve reactions that are self-limiting, meaning they stop when a certain condition is met. These reactions can comprise chemisorption, deposition, extraction, oxidation, nitridation, or conversion. Self-limiting reaction processes can be performed during or after the high pressure dry etching process. These self-limiting reactions can further enhance the results of the etching process by providing additional control over the etching process.

In some examples, the etching or self-limiting reactions can be selectively applied to specific areas of the substrate. This selective application allows for the targeted reduction of sidewall roughness in specific areas, while preserving the dimensions of the features in other areas.

### 4. Description of further Examples of the Disclosure

In one example, the method for sidewall roughness reduction can comprise the use of atomic layer etching, and particle beam etching selective to silicon oxide and silicon. The method can also comprise a cyclic etching process.

### 4.1. Use of Atomic Layer Etching

In some implementations, atomic layer etching (ALE) is used in the method for sidewall roughness reduction. Atomic layer etching (ALE) is defined as an etching technique that uses sequential half-reactions resulting in layer-by-layer material subtraction. The ALE implementation consists of at least two sequential steps: surface modification (reaction A) and removal (reaction B). These reactions can be cycled, and at least one step is at least partly self-limiting. The modification step forms a thin reactive surface layer with a well-defined thickness that is subsequently more easily removed than the unmodified material. The layer is characterized by a sharp gradient in chemical composition. Removal methods include thermal desorption, particle bombardment, and chemical reaction. ALE processes may also include quasi-atomic layer etching processes, which may include quasi-self-limiting reactions and non-self-limiting reactions. This provides a high level of control over the etching process, which can help to achieve a high level of roughness reduction.

ALE is defined as an etching technique that uses sequential half-reactions resulting in layer-by-layer material subtraction. The ALE implementation consists of at least two sequential steps: surface modification (reaction A) and removal (reaction B). These reactions can be cycled, and at least one step is at least partly self-limiting. The modification step forms a thin reactive surface layer with a well-defined thickness that is subsequently more easily removed than the unmodified material. The layer is characterized by a sharp gradient in chemical composition. Removal methods include thermal desorption, particle bombardment, and chemical reaction. The above-described ALE method can comprise quasi-atomic layer etching processes, which may include quasi-self-limiting reactions and non-self-limiting reactions.

### 4.1.1. Particle Beam Etching Selective to Silicon Oxide and Silicon

In some configurations, particle beam etching selective to silicon oxide and silicon is used in the method for sidewall roughness reduction. This type of etching process involves the use of a particle beam that is selective to silicon oxide and silicon, meaning it preferentially etches these materials. This selectivity can help to preserve the dimensions of the features while reducing the roughness of the sidewalls. In further examples, the etching is selective to a material comprising silicon nitride, hafnium oxide, and/or aluminium oxide.

### 4.2. Cyclic Etching Process

In some examples, the method for sidewall roughness reduction comprises a cyclic etching process in which the material is removed in an atomic level in each cycle. Each cycle may thus remove a small amount of material from the sidewalls. This cyclic process can help to achieve a high level of control over the etching process, which can result in a high level of roughness reduction. The method can comprise rapidly changing the temperature of the substrate surface between each etching cycle. This can help to further enhance the results of the etching process by providing additional control over the etching process.

Further, each of the etching cycles could have a step that could help lowering the binding energy of the surface atoms. The applied gas phase material reacts with the sidewall 200 and lowers the energy of its material so that a low energy plasma (another step in a cycle) can remove it. An example of such a process could be as following. A semiconductor, metal, dielectric or polymer surface is patterned by any type of lithography and then it moves to an ALD chamber where the top surface is covered with mask then it moves to another chamber, ICP-RIE, where it is exposed to a cyclic etching. The etching comprises a step in which surfaces are exposed to a reactive gas such as Cl-gas. Excess CI may be removed and a low power plasma, 10-20 eV may be applied to sputter away the roughness. The sputtering plasma could be a neutral gas like Ar or any other gases like SF₆ and C₄F₈. The chamber pressure may be 60 mTorr. As a result, the roughness can be significantly improved, such as a line edge roughness in the range 5-10 Angstrom (Å) to less than 1-10 Å.

### 5. Potential Applications

In one example, the method for sidewall roughness reduction can be applied in atomic level pitch splitting. This is a process where a larger structure on the substrate is divided into two or more smaller structures. The method can also be used with various material types, including semiconductors, metals, dielectrics, and polymers.

### 5.1. Application in Atomic Level Pitch Splitting

In some implementations, the method for sidewall roughness reduction can be used in atomic level pitch splitting (APS). This process involves dividing a larger structure on the substrate into two or more smaller structures. In some configurations, the use of the method for sidewall roughness reduction in atomic level pitch splitting can have a significant impact on the size and profile of the smaller structures. The method can help to reduce the roughness of the sidewalls of the smaller structures, which can result in smoother and more uniform structures. This can improve the performance of the structures in their intended applications.

### 5.2. Application in Semiconductors, Metals, Dielectrics, and Polymers

In some configurations, the method for sidewall roughness reduction can be applied to features made from a variety of materials, including semiconductors, metals, dielectrics, and polymers. The method can help to reduce the roughness of the sidewalls of features made from these materials, which can improve their performance in their intended applications. The method can be adapted to suit the specific properties of each material type, ensuring that the roughness of the sidewalls is effectively reduced without damaging the material or altering its properties. This versatility makes the method suitable for use in a wide range of applications, from semiconductor manufacturing to the production of polymer-based devices.

### 5.3. Impact on Different Feature Shapes

In some examples, the method for sidewall roughness reduction can be used on features of various shapes. These can include ridges, trenches, holes, pillars, and more. The method can be adapted to suit the specific shape of each feature, ensuring that the roughness of the sidewalls is effectively reduced without altering the shape of the feature. This flexibility makes the method suitable for use in a wide range of applications, from the production of complex semiconductor devices to the fabrication of intricate polymer-based structures. The method can be particularly beneficial in applications where the shape of the feature is to its performance, as it allows for the reduction of sidewall roughness without compromising the shape of the feature.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A method for sidewall roughness reduction of features on a substrate, the features being spaced apart and having respective field regions and sidewalls, the method comprising
forming a patterned and selectively protecting masking layer so that at least part of the field regions are masked and the sidewalls are unmasked,
performing dry etching in a process chamber enclosing the substrate, comprising creating a horizontal component of a direction of the etching by setting a pressure in the process chamber to exceed a defined pressure threshold for a sidewall etching, whereby the horizontal component etches the unmasked sidewalls for said roughness reduction of the sidewalls.

2. The method according to claim 1, wherein the defined pressure threshold for sidewall etching is 40 mTorr.

3. The method according to claim 1 or 2, wherein the dry etching is self-limiting, whereby the dry etching stops when the sidewall roughness is reduced with a threshold amount.

4. The method according to any of claims 1 to 3, wherein the sidewall roughness is reduced by at least 50%.

5. The method according to any of claims 1 to 4, wherein a line edge roughness of the sidewalls is reduced to a value below 1 nm RMS.

6. The method according to any of claims 1 to 5, further comprising a self-limiting reaction such as chemisorption, deposition, extraction, oxidation, nitridation, or conversion.

7. The method according to claim 6, wherein the self-limiting reaction or dry etching is selectively applied to specific areas of the substrate.

8. The method according to any of claims 1 - 7, wherein the dry etching is a cyclic etching process.

9. The method according to any of claims 1 - 8, wherein the dry etching is performed using atomic layer etching (ALE).

10. The method according to any of claims 1 to 9, wherein the dry etching is selective to a material comprising any of silicon, silicon oxide, silicon nitride, hafnium oxide, aluminium oxide.

11. The method according to any of claims 1 to 10, further comprising rapid surface temperature cycling.

12. The method according to claim 11, wherein the rapid surface temperature cycling is done through surface exposure to plasma.

13. The method according to claim 11, wherein the rapid surface temperature cycling is assisted with flashlight.

14. The method according to claim 13, wherein the rapid surface temperature cycling assisted with flashlight is done using a laser light source.

15. The method according to any of claims 1 to 14, wherein the features on the substrate comprise any of micro- and nano-scale devices, waveguides, transistors, ridges, trenches, holes, and/or pillars.
